# FASCICULE DE BREVET EUROPEEN

(11) **EP 1 817 445 B1**
(45) Date de publication et mention de la délivrance du brevet: **30.06.2010**
(21) Numéro de dépôt: 05857330.4
(22) Date de dépôt: 25.11.2005
(51) Int. Cl.: C30B 33/02, C30B 31/22, H01L 21/762

(54) **PROCEDE DE REALISATION D'UN SUBSTRAT DEMONTABLE**
VERFAHREN ZUR HERSTELLUNG EINES ZERLEGBAREN SUBSTRATS
METHOD FOR MAKING A DISMOUNTABLE SUBSTRATE

(30) Priorité: 29.11.2004 FR 0452796
(43) Date de publication de la demande: 15.08.2007
(73) Titulaire: Commissariat à l'Énergie Atomique et aux Énergies Alternatives, 75015 Paris (FR)
(72) Inventeur: TAUZIN, Aurélie, F-38120 SAINT EGREVE (FR); LAGAHE-BLANCHARD, Chrystelle, F-38134 Saint Joseph de Rivière (FR)
(74) Mandataire: Poulin, Gérard
(86) Numéro de dépôt international: PCT/FR2005/050994
(87) Numéro de publication internationale: WO 2006/090034

(56) Documents cités:
- FR-A- 2 830 983
- US-A- 4 579 621
- US-A- 5 494 835
- US-B1- 6 291 326
- YUN C H ET AL: "THERMAL AND MECHANICAL SEPARATIONS OF SILLICON LAYERS FROM HYDROGEN PATTERN-IMPLANTED WAFERS" JOURNAL OF ELECTRONIC MATERIALS, WARRENDALE, PA, US, vol. 30, no. 8, août 2001 (2001-08), pages 960-964, XP008005517

## Description

### DOMAINE TECHNIQUE

L'invention concerne un procédé permettant de réaliser un masque de croissance sur un substrat. L'invention permet également d'obtenir des substrats démontables, c'est-à-dire des substrats comportant une couche mince sur un de leurs faces, cette couche mince étant détachable par l'application de contraintes par exemple.

### ÉTAT DE LA TECHNIQUE ANTÉRIEURE

Les dispositifs électroniques comprennent souvent des couches minces actives, dans lesquelles les événements électriques ont lieu. Ces couches minces sont généralement obtenues par épitaxie sur des substrats monocristallins de grande pureté. Or l'utilisation de tels substrats rend la fabrication des couches minces coûteuse. Un moyen pour obtenir des couches minces de moindre coût est de réaliser ce qu'on appelle des substrats démontables. Ces substrats démontables sont des substrats fragilisés comprenant une couche superficielle, située entre la surface du substrat et une zone enterrée fragilisée. En appliquant des contraintes sur le substrat démontable, on peut détacher la couche superficielle du substrat et ainsi obtenir une couche mince active.

Ces substrats démontables sont compatibles avec la mise en oeuvre d'étapes technologiques destinées à fabriquer des composants comprenant des couches minces actives. Ces substrats démontables présentent un intérêt croissant, notamment dans le domaine des dispositifs photovoltaïques, où leur utilisation permet d'obtenir des dispositifs photovoltaïques à bas coût.

Jusqu'à présent, plusieurs auteurs ont proposés des procédés de réalisation de substrats démontables (voir les documents **[1], [2], [3]** référencés à la fin de la description. Le brevet FR 2 830 983 décrit un procédé de fabrication de couches minces par implantation localisée suivant un motif défini par un masque puis séparation d'une partie de la couche. Le brevet US 4 579 621 décrit l'obtention d'un masque de croissance par attaque chimique suivant un masque pré-établi. Aussi Yun et al, dans "thermal and mechanical separations of silicon layers from hydrogen pattern-implanted wafers", J. of electr. mat. vol 30, n°8, page 960-964 (2001) décrit le procédé de transfert de motif après implantation. De manière générale, les procédés de réalisation connus de substrats démontables comportent les étapes suivantes :
- formation d'un masque de croissance sur un substrat cristallin,
- dépôt d'un cristal dans les zones exposées du substrat, c'est-à-dire dans les zones du substrat non recouvertes par le masque, dans des conditions telles que la croissance du cristal débute dans les zones exposées du substrat, puis se poursuit latéralement sur la surface entière du masque,
- poursuite du dépôt et de la croissance jusqu'à former une couche mince active de matériau cristallin de dimensions désirées sur toute la surface du masque.

Une étape supplémentaire de détachement de la couche mince active de matériau cristallin du reste du substrat permet d'obtenir une couche mince.

L'étape de formation du masque de croissance sur le substrat cristallin se fait, par exemple, par formation d'un oxyde thermique sur le substrat, suivie d'une étape de photolithographie et d'une attaque chimique sélective. Les étapes de photolithographie et d'attaque chimique comprennent l'étalement d'une résine photosensible, l'exposition de la résine selon un masque prédéfini, la gravure sélective de la résine exposée, une attaque chimique sélective pour graver l'oxyde dans les régions où la résine a été exposée/gravée et une élimination par voie chimique de la résine restante. On voit ainsi que l'étape de formation du masque de croissance est une étape longue et coûteuse.

### EXPOSÉ DE L'INVENTION

Un des buts de l'invention est de proposer une nouvelle méthode pour former un masque de croissance sur un substrat déterminé.

L'invention concerne ainsi un procédé de réalisation d'un masque de croissance à la surface d'un substrat initial cristallin, comprenant les étapes suivantes :
- formation d'une couche de deuxième matériau sur une des faces du substrat initial de premier matériau,
- formation d'un motif dans l'épaisseur de la couche de deuxième matériau de manière à exposer des zones de ladite face du substrat initial, ces zones formant des fenêtres de croissance sur le substrat initial,
   le procédé étant **caractérisé en ce que** la formation du motif est obtenue par implantation ionique réalisée dans la couche superficielle du substrat initial sous-jacente à la couche de deuxième matériau, les conditions d'implantation étant telles qu'elles provoquent, directement ou suite à un traitement thermique, sur ladite face du substrat initial l'apparition de zones exfoliées de premier matériau entraînant le retrait localisé des zones de deuxième matériau recouvrant les zones exfoliées de premier matériau, exposant ainsi localement le substrat initial et formant les fenêtres de croissance sur le substrat initial.

L'implantation ionique du substrat initial cristallin peut être réalisée en utilisant des espèces gazeuses (telles que H, He, gaz rares). L'implantation peut être réalisée au moyen d'un faisceau d'ions ou par immersion plasma.

Les conditions d'implantation sont choisies de sorte que des fenêtres de croissance apparaissent à la surface du substrat au niveau où certaines zones de la surface du substrat initial ont été exfoliées, ces zones exfoliées apparaissant directement après l'implantation ionique ou éventuellement après un traitement thermique réalisé après l'implantation. Chaque zone exfoliée constitue une fenêtre de croissance puisque le substrat y est mis à nu.

Avantageusement, la formation de la couche de deuxième matériau est obtenue par oxydation de la face du substrat de premier matériau.

Avantageusement, la formation de la couche de deuxième matériau est réalisée par dépôt (par exemple par plasma ou PECVD) du deuxième matériau sur une face du substrat initial de premier matériau.

L'invention concerne également un procédé de réalisation d'au moins une couche mince cristalline sur un substrat initial cristallin, **caractérisé en ce qu'**il comprend les étapes suivantes :
- formation d'un masque de croissance sur au moins une face d'un substrat initial cristallin de premier matériau selon le procédé de réalisation vu précédemment,
- formation d'une couche mince cristalline de troisième matériau sur la (les) face(s) du substrat comportant le (les) masque(s).

Notons que la couche mince cristalline peut être continue ou discontinue.

On obtient ainsi un substrat dit démontable. On rappelle qu'un substrat démontable est un substrat comprenant une couche superficielle (comportant la couche mince) délimitée par la surface du substrat et par une zone enterrée fragilisée. Le substrat est dit démontable car il comporte une couche mince supérieure qui peut être séparée du substrat initial par l'application de contraintes. Le substrat comporte une zone enterrée fragilisée car l'implantation ionique induit également, en plus de la formation de zones exfoliées, la formation d'une couche de microcavités enterrées au niveau de la zone implantée.

Selon une variante, on peut réaliser simultanément deux couches minces cristallines sur un même substrat, par exemple en formant un masque sur les deux faces opposées d'un substrat initial cristallin, puis en formant deux couches minces cristallines sur les deux faces comportant chacune un masque.

Le substrat initial est en un matériau cristallin favorisant ainsi la croissance de la couche mince cristalline en troisième matériau sur sa surface.

De préférence, le matériau formant le masque de croissance (deuxième matériau) est un matériau ne favorisant pas la croissance de la couche mince : le matériau formant la couche mince ira donc en priorité sur les zones exposées du substrat initial.

La formation de la couche mince de troisième matériau est réalisée dans des conditions telles que la croissance du troisième matériau débute dans les zones exposées du substrat cristallin, puis se poursuit latéralement jusqu'à pouvoir recouvrir la surface entière du masque.

Avantageusement, la formation de la couche mince de troisième matériau est réalisée par croissance latérale du troisième matériau à partir des fenêtres de croissance sur le substrat initial. La croissance latérale peut être une croissance ELOG (« Epitaxial Lateral Overgrowth » en anglais). Le troisième matériau va ainsi croître à partir des fenêtres de croissance où le substrat initial est découvert et sa surface exfoliée, la structure cristalline du troisième matériau étant obtenue grâce à la structure cristalline du substrat initial.

Avantageusement, le premier matériau et le troisième matériau sont identiques. Le substrat initial peut ainsi être un substrat cristallin recouvert par un masque en un deuxième matériau, ledit matériau constituant une couche de masquage pour le dépôt et la croissance d'une couche mince cristalline identique au substrat. On obtient alors un substrat démontable comportant sur une de ses faces une couche mince cristalline de même matériau que le substrat initial qui peut être séparée du substrat par l'application de contraintes.

L'invention permet également d'obtenir des couches minces à partir de substrats.

L'invention concerne un procédé de réalisation d'une couche mince cristalline, comprenant les étapes suivantes :
- formation d'une couche mince cristalline sur une face d'un substrat initial cristallin de premier matériau comportant un masque de croissance de deuxième matériau selon le procédé de réalisation d'une couche mince cristalline sur un substrat cristallin vu précédemment,
- détachement de la couche mince cristalline du substrat initial cristallin.

On obtient alors d'une part une couche mince cristalline de troisième matériau de dimensions (notamment d'épaisseur) désirées, et d'autre part un substrat cristallin de premier matériau recyclable.

Avantageusement, le détachement de la couche mince du substrat initial est obtenu par l'application de contraintes mécaniques et/ou chimiques. Il peut s'agir de contraintes mécaniques en traction et/ou en cisaillement. Le détachement peut résulter de l'application de contraintes d'ouverture au niveau de la zone fragile enterrée (c'est-à-dire la zone où se trouvent les microcavités), ou encore d'une attaque chimique sélective de la couche fragilisée et/ou de la couche de deuxième matériau (masque). Le détachement peut également résulter d'une combinaison de ces méthodes.

Enfin, l'invention concerne un procédé de report d'une couche mince cristalline sur un substrat de réception, ledit procédé comprenant les étapes suivantes :
- formation d'une couche mince cristalline de troisième matériau sur une face d'un substrat initial cristallin de premier matériau comportant un masque de croissance de deuxième matériau selon le procédé de réalisation d'une couche mince cristalline sur un substrat cristallin vu précédemment,
- mise en contact et adhésion de la couche mince cristalline sur une face d'un substrat de réception,
- détachement de la couche mince cristalline du substrat initial cristallin de manière à séparer le substrat initial du substrat de réception, le substrat de réception supportant la couche mince cristalline.

Avantageusement, l'adhésion de la couche mince sur une face d'un substrat de réception est obtenue en formant une couche d'adhésion sur la couche mince et/ou sur le substrat de réception. En variante, l'adhésion peut être obtenue par collage par adhésion moléculaire.

Avantageusement, l'étape de détachement de la couche mince est réalisée en appliquant des contraintes mécaniques et/ou chimiques. On peut ainsi appliquer des contraintes mécaniques à la structure collée, par exemple au niveau de la zone fragile enterrée. La contrainte mécanique peut consister à insérer une lame entre le substrat initial et le substrat de réception et/ou exercer des efforts de traction et/ou de flexion et/ou de cisaillement sur la structure collée. On peut également appliquer à la structure collée des ultrasons ou des micro-ondes de puissance et de fréquence judicieusement choisies.

Avantageusement, le procédé de report d'une couche mince cristalline sur un substrat de réception selon l'invention comprend en outre, après l'étape de formation de la couche mince cristalline, une étape d'attaque chimique du masque de croissance de deuxième matériau. Cette étape supplémentaire permet de faciliter le détachement de la couche mince. Cette étape peut être réalisée avant ou après le collage sur le substrat de réception.

Les différents procédés selon l'invention présentent de nombreux avantages par rapport à l'art antérieur.

Le procédé de réalisation d'un masque de croissance permet de former un masque de croissance à bas coût. En effet, avec ce procédé, les étapes de photolithographie et de gravure sélective sont avantageusement remplacées par une simple étape d'implantation ionique.

Par ailleurs, la présence des microcavités induites par l'implantation permet de fragiliser localement le substrat initial, ce qui permet de faciliter l'étape de détachement de la couche mince dans le procédé de réalisation d'une couche mince cristalline ou le procédé de report d'une couche mince cristalline sur un substrat de réception.

Les tailles et densités des zones exfoliées, mais également celles des microcavités, sont contrôlées et facilement adaptables. En effet, ces paramètres dépendent principalement des conditions d'implantation (c'est-à-dire la dose, l'énergie et la température de l'implantation) et des conditions de l'éventuel traitement thermique post-implantation (température, temps, rampes de température, atmosphère) appliquées pour un substrat initial et une couche mince déterminés. On peut ainsi moduler la répartition des fenêtres de croissance sur le substrat initial ainsi que le niveau de fragilisation de la zone fragile enterrée en choisissant judicieusement les conditions de l'implantation ionique et de l'éventuel traitement thermique.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1C présentent les différentes étapes du procédé de formation d'un masque sur un substrat initial selon l'invention,
- la figure 2 est une vue de dessus d'un détail de la figure 1C,
- les figures 3A à 3D illustrent des étapes du procédé de report de la couche mince sur un substrat de réception.

### EXPOSÉ DÉTAILLÉ DE MODES DE RÉALISATION PARTICULIERS

Dans un premier exemple, nous allons illustrer l'invention à l'aide d'un exemple de réalisation d'un substrat de silicium démontable composé d'un substrat de silicium comportant sur une de ses faces une couche mince de silicium.

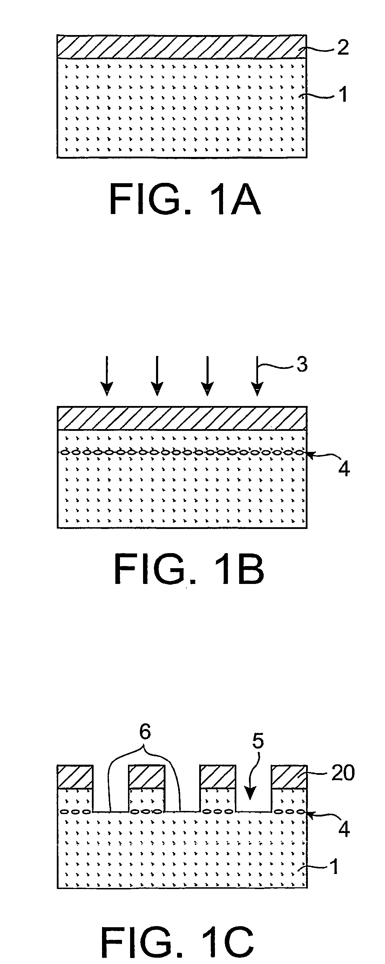

On utilise un substrat initial 1 de silicium monocristallin orienté (100) ou (111) et on lui fait subir une oxydation thermique. Cette couche d'oxydation de silice va nous permettre de réaliser un masque de croissance sur l'une voire les deux faces de ce substrat initial de silicium. L'oxydation du substrat de silicium est réalisée de manière à obtenir une couche d'oxyde de silicium ayant une épaisseur déterminée. L'épaisseur de cette couche doit en effet être suffisamment faible pour que l'implantation ionique ultérieure atteigne le substrat de silicium, mais suffisante pour former une couche de masquage pour la croissance ultérieure de la couche mince en silicium. Ici, l'oxydation est obtenue en plaçant le substrat de silicium dans un four à 1100°C sous flux d'oxygène à 760 Torr pendant environ 2 heures 30 ou à 900°C sous flux de vapeur d'eau à 760 Torr pendant 50 minutes par exemple. On obtient ainsi une couche d'oxyde 2 de 200 nm d'épaisseur sur un substrat initial 1 de silicium (voir figure 1A).

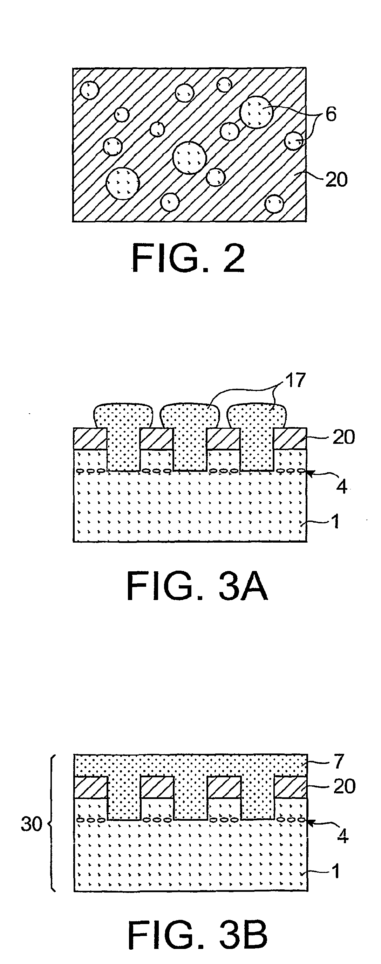

Selon une première variante, on réalise ensuite une étape d'implantation ionique 3 du substrat de silicium (figure 1B) à environ 40 KeV avec des ions H⁺ à 1.10¹⁷ H⁺/cm². Cette dose particulière d'ions H⁺ induit la formation de microcavités enterrées 4 dans le substrat de silicium et de zones exfoliées 5 en surface du substrat formant des fenêtres de croissance 6 sur le substrat initial (figure 1C et figure 2). Etant donné l'énergie d'implantation utilisée, les microcavités enterrées sont situées à une profondeur de 250 nm environ sous la surface du substrat 1, soit à une profondeur de 450 nm sous la surface de l'oxyde 2. On a ainsi un masque de croissance 20 sur le substrat de silicium 1.

Selon une seconde variante, l'étape d'implantation ionique peut être réalisée à environ 40 KeV avec des ions H⁺ à 5.10¹⁶ H⁺/cm². L'implantation ionique peut alors être suivie par un traitement thermique dans la gamme de température allant de 350°C à 1100°C. Le traitement thermique permet le développement de microcavités enterrées et la formation de zones exfoliées en surface du substrat en augmentant la pression de gaz à l'intérieur de ces microcavités. Avantageusement, le traitement thermique post-implantation est réalisé dans le même bâti d'épitaxie que celui utilisé pour la croissance de la couche mince. Ceci permet d'éviter la manipulation et/ou la contamination des structures entre ces deux étapes.

Dans une autre variante, l'implantation peut être réalisée avant le dépôt de l'oxyde servant à la réalisation du masque. On s'assurera dans ce cas que la couche d'oxyde déposée ait une épaisseur suffisamment faible pour éviter d'avoir un effet raidisseur entraînant la fracture de la structure au niveau de la zone fragile enterrée créée par implantation.

On obtient ainsi un masque de croissance 20 présentant des fenêtres de croissance 6 (au niveau des zones exfoliées 5 du substrat de silicium 1) de tailles, profondeurs et densités contrôlées par les conditions expérimentales d'implantation (dose, énergie, température) et/ou de traitement thermique (température, temps, rampe) et/ou le choix des matériaux du substrat et du masque, ces fenêtres de croissance donnant accès au substrat initial aux niveaux de zones exfoliées 5 du substrat initial 1 comme illustré dans la figure 2.

En variante, l'implantation peut être réalisée non par bombardement d'ions mais par immersion plasma. Cette technique a pour avantage de pouvoir agir simultanément sur les deux faces du substrat.

Sur la ou les faces du substrat 1 comportant le masque de croissance 20, on forme ensuite la couche mince 7 de silicium et on obtient ainsi un substrat démontable 30 (figure 3B). Cette couche mince 7 peut être obtenue par croissance latérale (ELOG) de silicium cristallin à partir des zones du substrat de silicium mises à nu (c'est-à-dire au niveau des fenêtres de croissance 6). Cette technique permet de favoriser la croissance latérale du silicium par rapport à sa croissance verticale. Ainsi, au fur et à mesure de sa croissance, le silicium recouvre progressivement le masque de croissance (voir la figure 3A où le silicium est représenté sous la forme de bouchons de champagne 17 débordant l'espace constitué par les zones exfoliées 5). Avantageusement, la croissance est poursuivie jusqu'à la coalescence du silicium sur toute la surface du masque de croissance (voir figure 3B). Il en résulte la formation d'une couche épitaxiale 7 continue, d'épaisseur désirée et de qualité cristalline. La couche mince 7 ainsi formée peut avoir une épaisseur de 50 µm par exemple.

La technique ELO est bien connue des hommes du métier. Dans le cas du silicium, le rapport entre les vitesses de croissance latérale et verticale dépend notamment de l'orientation cristallographique du substrat et est maximal pour les substrats (111). La croissance épitaxiale ELO commence au niveau des fenêtres de croissance du masque, puis la cristallisation des couches par dessus le masque se fait par nucléation bidimensionnelle. La croissance ELO permet de favoriser le recouvrement de l'oxyde plutôt que la croissance verticale. Une coalescence du silicium épitaxié est ainsi possible et on obtient une couche épitaxiée finale plate, continue, sans dislocations et présentant une rugosité de surface à l'échelle atomique. Dans le cas de substrats orientés (100), la croissance se fait préférentiellement selon les plans <111>. Dans un premier temps, on observe la formation de pyramides d'angle à la base de 54,7° dans chaque fenêtre de croissance du masque. Puis, au fur et à mesure de la croissance, il y a coalescence de ces pyramides par recouvrement de l'oxyde du masque lorsque les pyramides sont assez grandes et assez rapprochées.

La croissance de la couche mince de silicium peut être effectuée dans un bâti d'Epitaxie en Phase Liquide standard. Pour cela, on introduit en même temps le substrat à épitaxier (constitué du substrat initial 1 de silicium dont au moins une face est recouverte d'un masque de croissance en oxyde de silicium 20) ainsi qu'un bain de croissance composé de silicium et d'un solvant (étain ou indium) dans un four d'épitaxie sous un flux d'H₂ ultra-pur. Le substrat à épitaxier et le bain de croissance sont alors portés à haute température (environ 950°C) pendant environ 2 heures, jusqu'à ce que le bain de croissance, devenu liquide, soit saturé en silicium. Une fois saturé, le bain de croissance est mis en contact avec le substrat de silicium à épitaxier. Enfin, le bain et le substrat de croissance sont ensuite refroidis lentement (rampe de 0,5°C/min), afin que le bain et le substrat de croissance suivent la courbe d'équilibre thermodynamique liquide-solide du système Si-Solvant choisi. La couche mince épitaxiée 7 de silicium présente ainsi les mêmes caractéristiques cristallographiques que le substrat initial 1. Sachant que les vitesses de croissance sont de l'ordre de 0,1 à 1 µm/min, la croissance d'une couche de 50 µm de silicium <111> dure environ 2h.

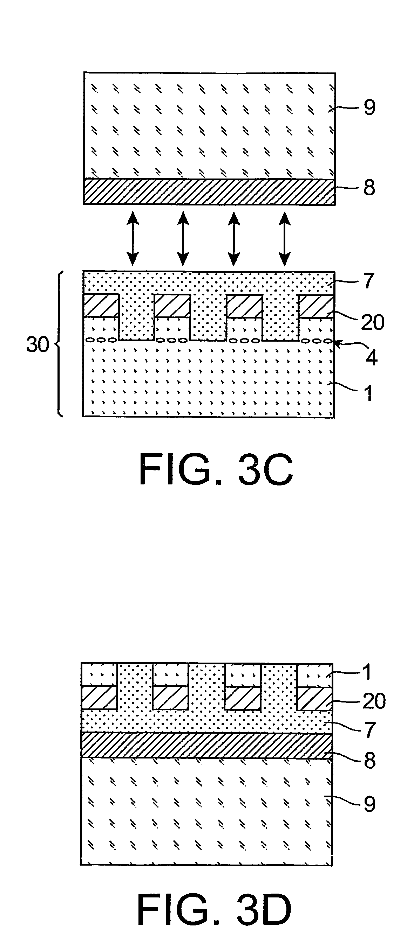

A partir de cette couche mince de silicium cristallin, on peut ensuite réaliser des composants tels que des cellules photovoltaïques. Ces composants peuvent ensuite être reportés sur un support économique. Pour cela, le substrat démontable 30 est collé pour tout ou partie sur un support final économique suivant la face comportant la couche mince 7 (figure 3C). On peut par exemple réaliser le collage en déposant une couche d'adhésion 8 sur une face du substrat de réception 9. La couche d'adhésion 8 peut être obtenue en utilisant des colles céramiques ou des colles polymères par exemple, et le support final (substrat de réception 9) peut être un support céramique. En variante, le collage peut être réalisé par adhésion moléculaire. On détache ensuite tout ou partie de la couche mince 7 de son substrat initial 1 en appliquant une contrainte de détachement sur la structure collée. On peut par exemple insérer une lame entre le substrat initial 1 et le substrat de réception 9 et/ou exercer des efforts de traction et/ou de flexion et/ou de cisaillement sur la structure collée, et/ou appliquer au niveau de la zone de microcavités enterrées et/ou de l'interface masque/couche mince des ultrasons ou des micro-ondes de puissance et de fréquence judicieusement choisies. Le détachement peut se produire au niveau de l'interface entre la couche mince 7 et le masque d'oxyde thermique 20, et/ou au niveau du masque d'oxyde thermique 20 (plus fragile que le silicium) et/ou au niveau de la zone de microcavités 4 située dans le substrat initial 1. Le substrat cristallin initial peut être alors recyclé et être réutilisé pour réaliser d'autres couches minces. Dans la figure 3D, on a représenté une couche mince 7 reportée sur un substrat de réception 9 dans lequel la séparation avec le substrat initial a eu lieu au niveau de la zone de microcavités. La couche mince 7 comporte ainsi le masque 20 et un reste du substrat initial 1. Selon une variante de détachement, on peut après formation de la couche mince 7, continue ou discontinue, réaliser une attaque chimique sélective pour éliminer tout ou partie du masque de croissance avant ou après collage du substrat de réception. Cette étape facilite le détachement de la couche mince par exemple par application de contraintes mécaniques simultanées ou ultérieures.

Avantageusement, après le report, on peut réaliser une attaque chimique sélective ou une étape de polissage mécano-chimique permettant d'éliminer les zones d'oxyde thermique (le masque 20), solidaires de la couche mince, de manière à ne conserver que la couche mince 7 reportée sur le substrat 9. Cette couche peut subir les opérations technologiques (dépôt, gravure) nécessaires à la réalisation de composants.

Un autre exemple de réalisation d'un substrat démontable est présenté ci-dessous. On utilise un substrat initial en germanium monocristallin orienté (100) ou (111). Sur ce substrat, on dépose une couche de SiO₂ d'épaisseur 250 nm par PECVD (« Plasma Enhanced Chemical Vapour Deposition » en anglais).

Selon une première variante, on réalise une implantation ionique du substrat avec une quantité d'ions H⁺ de 1.10¹⁷ H⁺/cm² à une énergie de 80 KeV. Ces conditions d'implantation induisent la formation de microcavités enterrées à une profondeur déterminée du substrat et l'apparition de zones exfoliées en surface du substrat. Au final, la couche de silice présente des fenêtres de croissance qui mettent à nu le substrat sous-jacent de germanium.

Selon une seconde variante, l'étape d'implantation est réalisée avec une dose d'ions de 5.10¹⁶ H⁺/cm² à une énergie de 80 KeV. Cette étape est suivie par un traitement thermique effectué à une température comprise entre 350°C et 500°C. Avantageusement, le traitement thermique post-implantation est réalisé dans un bâti d'épitaxie.

En variante, l'implantation peut être réalisée avant le dépôt du masque.

On obtient ainsi un masque de croissance présentant des fenêtres de croissance de taille, profondeur et densités contrôlées par les conditions expérimentales.

Sur un tel substrat muni de son masque de croissance, on réalise un dépôt ou une croissance de germanium à partir des zones de germanium mis à nu (zones exfoliées visibles dans les fenêtres de croissance du masque). La croissance peut par exemple être effectuée dans un bâti d'épitaxie en Phase Liquide standard. On utilise pour cela un bain de croissance composé de germanium et d'un solvant (par exemple un solvant contenant du plomb). Le bain de croissance et le substrat à épitaxier, muni de son masque de croissance, sont introduits en même temps dans un four. Le four est purgé avec de l'argon, puis le système est mis sous vide à 5.10⁻⁶ Torr. Le four est ensuite porté à 300°C sous flux d'H₂ ultra-pur (le débit d'H₂ est de 1L/min). Le bain de croissance et le substrat à épitaxier sont portés à haute température (environ 655°C) pendant environ 5 heures 1/2, jusqu'à ce que le bain de croissance devenu liquide soit saturé en germanium. Une fois saturé, le bain de croissance est mis en contact avec le substrat germanium à épitaxier à une température d'environ 653°C. La légère différence de température (environ 2°C) par rapport à la température de saturation permet d'initier la croissance. Le bain et le substrat de croissance sont ensuite refroidis jusqu'à une température de 340°C en 12 heures. L'épaisseur de la couche épitaxiale ainsi obtenue est de l'ordre de 35 à 50 µm.

A partir de cette couche mince de germanium, on peut réaliser certaines étapes technologiques de fabrication de composants, comme par exemple la réalisation de cellules photovoltaïques. Ces composants peuvent encore être reportés sur un substrat de réception. Par exemple, on peut transférer tout ou partir de la couche épitaxiale de germanium, éventuellement traitée, sur un autre support que le substrat initial. Pour cela, on colle la couche mince de germanium sur un support final économique (par exemple un substrat de réception en céramique) en utilisant une couche d'adhésion (colles céramiques, colles polymères,...). Puis, par l'application d'une contrainte de détachement, on détache la couche mince de germanium de son substrat initial. Le détachement peut se produire au niveau de l'interface couche mince/oxyde de silicium, et/ou dans la couche d'oxyde de silicium (plus fragile que le germanium) et/ou au niveau de la zone de microcavités du substrat initial. Le détachement peut être obtenu en insérant une lame entre les deux substrats, c'est-à-dire le substrat initial et le substrat de réception, et/ou encore en exerçant des efforts de traction et/ou de flexion et/ou de cisaillement sur le substrat initial, et/ou encore en appliquant des ultrasons ou des micro-ondes de puissance et de fréquence judicieusement choisies sur le substrat initial. Selon une variante, on peut réaliser une attaque chimique sélective pour graver les zones d'oxyde du masque de croissance, en combinaison avec l'application d'une contrainte de détachement afin de faciliter le détachement.

Avantageusement, on élimine les restes du substrat initial et du masque de croissance par voie chimique et/ou polissage mécano-chimique de manière à restituer à la couche 7 reportée un bon état de surface. Différentes étapes technologiques de fabrication de composants peuvent alors être effectuées sur la couche 7 reportée (par exemple un dépôt PECVD, une gravure, une sérigraphie).

### BIBLIOGRAPHIE

[1] Brevet W081/02948, avril 1980
[2] K.J. Weber, "Lift-off of silicon epitaxial layers for solar cell applications", 26t PVSC, 1997, Anaheim, CA
[3] H. Raidt, "Adhesion in growth of defect-free silicon over silicon oxide", J. Appl. Phys. 80 (7), 1996, p 4101

## Revendications

1. Procédé de réalisation d'un masque de croissance (20) à la surface d'un substrat initial (1) cristallin, comprenant les étapes suivantes :
- formation d'une couche de deuxième matériau (2) sur une des faces du substrat initial (1) de premier matériau,
- formation d'un motif dans l'épaisseur de la couche de deuxième matériau (2) de manière à exposer des zones de ladite face du substrat initial, ces zones formant des fenêtres de croissance sur le substrat initial,
le procédé étant **caractérisé en ce que** la formation du motif est obtenue par implantation ionique (3) réalisée dans la couche superficielle du substrat initial (1) sous-jacente à la couche de deuxième matériau (2), les conditions d'implantation étant telles qu'elles provoquent, directement ou suite à un traitement thermique, sur ladite face du substrat initial, l'apparition de zones exfoliées (5) de premier matériau entraînant le retrait localisé des zones de deuxième matériau recouvrant les zones exfoliées (5) de premier matériau, exposant ainsi localement le substrat initial (1) et formant les fenêtres de croissance (6) sur le substrat initial.

2. Procédé de réalisation d'un masque selon la revendication précédente, **caractérisé en ce que** la formation de la couche de deuxième matériau (2) est obtenue par oxydation de la face du substrat de premier matériau (1).

3. Procédé de réalisation d'un masque selon la revendication 1, **caractérisé en ce que** la formation de la couche de deuxième matériau (2) est réalisée par dépôt du deuxième matériau sur une face du substrat initial (1) de premier matériau.

4. Procédé de réalisation d'au moins une couche mince cristalline sur un substrat initial cristallin, **caractérisé en ce qu'**il comprend les étapes suivantes :
- formation d'un masque de croissance (20) sur au moins une face d'un substrat initial (1) cristallin de premier matériau selon l'une quelconque des revendications 1 à 3,
- formation d'une couche mince (7) cristalline de troisième matériau sur la (les) face(s) du substrat comportant le (les) masque(s) (20).

5. Procédé de réalisation d'au moins une couche mince selon la revendication 4, **caractérisé en ce que** la formation de la couche mince (7) de troisième matériau est réalisée par croissance latérale du troisième matériau à partir des fenêtres de croissance (6) sur le substrat initial (1).

6. Procédé de réalisation d'au moins une couche mince selon la revendication 4 ou 5, **caractérisé en ce** le premier matériau et le troisième matériau sont identiques.

7. Procédé de réalisation d'une couche mince cristalline, comprenant les étapes suivantes :
- formation d'une couche mince (7) cristalline sur une face d'un substrat initial (1) cristallin de premier matériau comportant un masque de croissance (20) de deuxième matériau selon l'une quelconque des revendications 4 à 6,
- détachement de la couche mince (7) cristalline du substrat initial (1) cristallin.

8. Procédé de réalisation d'une couche mince selon la revendication précédente, **caractérisé en ce que** le détachement de la couche mince (7) du substrat initial est obtenu par l'application de contraintes mécaniques et/ou chimiques.

9. Procédé de report d'une couche mince cristalline sur un substrat de réception, ledit procédé comprenant les étapes suivantes :
- formation d'une couche mince (7) cristalline de troisième matériau sur une face d'un substrat initial (1) cristallin de premier matériau comportant un masque de croissance (20) de deuxième matériau selon l'une quelconque des revendications 4 à 6,
- mise en contact et adhésion de la couche mince (7) cristalline sur une face d'un substrat de réception (9),
- détachement de la couche mince (7) cristalline du substrat initial (1) cristallin de manière à séparer le substrat initial du substrat de réception, le substrat de réception supportant la couche mince cristalline.

10. Procédé de report d'une couche mince cristalline sur un substrat de réception selon la revendication précédente, **caractérisé en ce que** l'adhésion de la couche mince (7) sur une face d'un substrat de réception (9) est obtenue en formant une couche d'adhésion (8) sur la couche mince et/ou sur le substrat de réception.

11. Procédé de report d'une couche mince cristalline sur un substrat de réception selon la revendication 9, **caractérisé en ce que** l'adhésion de la couche mince (7) sur une face d'un substrat de réception (9) est obtenue par collage par adhésion moléculaire.

12. Procédé de report d'une couche mince cristalline sur un substrat de réception selon l'une quelconque des revendications 9 à 11, **caractérisé en ce que** l'étape de détachement de la couche mince (7) est réalisée en appliquant des contraintes mécaniques et/ou chimiques.

13. Procédé de report d'une couche mince cristalline sur un substrat de réception selon l'une quelconque des revendications 9 à 12, **caractérisé en ce qu'**il comprend en outre, après l'étape de formation de la couche mince (7) cristalline, une étape d'attaque chimique du masque de croissance (20) de deuxième matériau.

## Claims

1. Method for forming a growth mask (20) on the surface of an initial crystalline substrate (1), comprising the following steps:
- formation of a layer of second material (2) on one of the faces of the initial substrate (1) of first material,
- formation of a pattern in the thickness of the layer of second material (2) so as to expose zones of said face of the initial substrate, said zones forming growth windows on the initial substrate,
the method being **characterised in that** the formation of the pattern is obtained by ion implantation (3) carried out in the surface layer of the initial substrate (1) underlying the layer of second material (2), the implantation conditions being such that they cause, directly or after a heat treatment, on said face of the initial substrate, the appearance of exfoliated zones (5) of first material leading to the localised removal of the zones of second material covering the exfoliated zones (5) of first material, thereby locally exposing the initial substrate (1) and forming growth windows (6) on the initial substrate.

2. Method for forming a mask according to claim 1, **characterised in that** the formation of the layer of second material (2) is obtained by oxidation of the face of the substrate of first material (1).

3. Method for forming a mask according to claim 1, **characterised in that** the formation of the layer of second material (2) is formed by deposition of the second material on a face of the initial substrate (1) of first material.

4. Method for forming at least one crystalline thin film on an initial crystalline substrate, **characterised in that** it comprises the following steps:
- formation of a growth mask (20) on at least one face of an initial crystalline substrate (1) of first material according to any of claims 1 to 3,
- formation of a crystalline thin film (7) of third material on the face(s) of the substrate comprising the mask(s) (20).

5. Method for forming at least one thin film according to claim 4, **characterised in that** the formation of the thin film (7) of third material is carried out by literal growth of the third material from growth windows (6) on the initial substrate (1).

6. Method for forming at least one thin film according to claim 4 or 5, **characterised in that** the first material and the third material are identical.

7. Method for forming a crystalline thin film, comprising the following steps:
- formation of a crystalline thin film (7) on a face of an initial crystalline substrate (1) of first material comprising a growth mask (20) of second material according to any of claims 4 to 6,
- detachment of the crystalline thin film (7) from the initial crystalline substrate (1).

8. Method for forming a thin film according to claim 7, **characterised in that** the detachment of the thin film (7) from the initial substrate is obtained by the application of mechanical and/or chemical stresses.

9. Method for transferring a crystalline thin film onto a host substrate, said method comprising the following steps:
- formation of a crystalline thin film (7) of third material on a face of an initial crystalline substrate (1) of first material comprising a growth mask (20) of second material according to any of claims 4 to 6,
- bringing into contact and adhesion of the crystalline thin film (7) on a face of a host substrate (9),
- detachment of the crystalline thin film (7) from the initial crystalline substrate (1) so as to separate the initial substrate from the host substrate, the host substrate supporting the crystalline thin film.

10. Method for transferring a crystalline thin film onto a host substrate according to claim 9, **characterised in that** the adhesion of the thin film (7) on a face of a host substrate (9) is obtained by forming an adhesion layer (8) on the thin film and/or on the host substrate.

11. Method for transferring a crystalline thin film onto a host substrate according to claim 9, **characterised in that** the adhesion of the thin film (7) on a face of a host substrate (9) is obtained through bonding by molecular adhesion.

12. Method for transferring a crystalline thin film onto a host substrate according to any of claims 9 to 11, **characterised in that** the step of detachment of the thin film (7) is carried out by applying mechanical and/or chemical stresses.

13. Method for transferring a crystalline thin film onto a host substrate according to any of claims 9 to 12, **characterised in that** it further comprises, after the step of formation of the crystalline thin film (7), a step of chemical attack of the growth mask (20) of second material.

## Patentansprüche

1. Verfahren zur Herstellung einer Wachstumsmaske (20) auf der Oberfläche eines kristallinen Ausgangs- bzw. Anfangssubstrats (1), wobei das Verfahren die folgenden Verfahrensstufen bzw. -schritte umfasst:
- Ausbilden einer Schicht (2) aus einem zweiten Material auf einer der Oberflächen des Anfangssubstrats (1) aus einem ersten Material,
- Ausbilden einer Motivstruktur über die Materialstärke der Schicht (2) aus dem zweiten Material derart, dass Zonen der genannten Oberfläche des Anfangssubstrats freigelegt werden, wobei diese Zonen Wachstumsfenster auf dem Anfangssubstrat bilden, das Verfahren
**dadurch gekennzeichnet, dass** die Ausbildung der Motivstruktur mittels lonenimplantation (3) erfolgt, die in der unterhalb der Schicht (2) aus dem zweiten Material liegenden Oberflächenschicht des Anfangssubstrats (1) vorgenommen wird, wobei die Implantationsbedingungen solcher Art sind, dass sie, direkt oder nach einer Wärmebehandlung, auf der genannten Oberfläche des Anfangssubstrats das Auftreten versprödeter Zonen (5) des ersten Materials bewirken, was die lokalisierte Rückschrumpfung der Zonen des zweiten Materials zur Folge hat, welche die versprödeten Zonen (5) aus dem ersten Material über-decken, wodurch so örtlich das Anfangssubstrat (1) freigelegt wird und die Wachstumsfenster (6) auf dem Anfangssubstrat gebildet werden.

2. Verfahren zur Herstellung einer Maske nach dem vorhergehenden Anspruch, **dadurch gekennzeichnet, dass** die Ausbildung der Schicht (2) aus dem zweiten Material durch Oxydation der Oberfläche des Substrats (1) aus dem ersten Material erfolgt.

3. Verfahren zur Erzeugung einer Maske nach Anspruch 1, **dadurch gekennzeichnet, dass** die Ausbildung der Schicht (2) aus dem zweiten Material durch Abscheiden des zweiten Materials auf einer Oberfläche des Anfangssubstrats (1) aus dem ersten Material erfolgt.

4. Verfahren zur Erzeugung wenigstens einer dünnen kristallinen Schicht auf einem kristallinen Anfangssubstrat, **dadurch gekennzeichnet, dass** das Verfahren die folgenden Stufen bzw. Schritte umfasst:
- Ausbilden einer Wachstumsmaske (20) auf wenigstens einer Oberfläche eines kristallinen Anfangssubstrats aus einem ersten Material gemäß einem beliebigen der Ansprüche 1 bis 3,
- Ausbilden einer dünnen kristallinen Schicht (7) aus einem dritten Material auf der/den die Maske(n) (20) tragenden Oberfläche(n) des Substrats.

5. Verfahren zur Erzeugung wenigstens einer dünnen Schicht nach Anspruch 4, **dadurch gekennzeichnet, dass** die Ausbildung der dünnen Schicht (7) aus dem dritten Material mittels Lateralwachstum des dritten Materials ausgehend von den Wachstumsfenstern (6) auf dem Anfangssubstrat (1) erfolgt.

6. Verfahren zur Erzeugung wenigstens einer dünnen Schicht nach den Ansprüchen 4 oder 5 , **dadurch gekennzeichnet, daß** das erste und das dritte Material identisch sind.

7. Verfahren zur Erzeugung wenigstens einer dünnen kristallinen Schicht, wobei das Verfahren die folgenden Schritte bzw. Stufen umfasst:
- Ausbilden einer dünnen kristallinen Schicht (7) auf einer eine Wachstumsmaske (20) tragenden Oberfläche eines kristallinen Anfangssubstrats (1) aus einem ersten Material, gemäß einem beliebigen der Ansprüche 4 bis 6,
- Abtrennen bzw. Ablösen der kristallinen Schicht (7) von dem kristallinen Anfangssubstrat (1).

8. Verfahren zur Erzeugung einer dünnen Schicht gemäß dem vorhergehenden Anspruch, **dadurch gekennzeichnet, dass** die Abtrennung bzw. Entfernung der dünnen Schicht (7) von dem Anfangssubstrat mittels Anwendung mechanischer und/oder chemischer Zwangsmaßnahmen erfolgt.

9. Verfahren zum Abziehen bzw. Abdruck einer dünnen kristallinen Schicht auf ein Aufnahme- bzw. Empfängersubstrat, wobei das Verfahren die folgenden Verfahrensschritte bzw. -stufen umfasst:
- Ausbilden einer dünnen kristallinen Schicht (7) aus einem dritten Material auf einer Oberfläche eines kristallinen Anfangssubstrats (1) aus einem ersten Material, welche eine Wachstumsmaske (20) aus einem zweiten Material trägt, nach einem beliebigen der Ansprüche 4 bis 6,
- die dünne kristalline Schicht (7) wird in Berührung mit und Anhaftung auf einer Oberfläche eines Empfänger- bzw. Aufnahmesubstrats (9) gebracht,
- Abtrennen bzw. Ablösen der dünnen kristallinen Schicht (7) von dem kristallinen Anfangssubstrat (1), um das Anfangssubstrat von dem Aufnahme-bzw. Empfängersubstrat zu trennen, wobei das Aufnahme- bzw. Empfängersubstrat die dünne kristalline Schicht trägt.

10. Verfahren zum Abziehen bzw. Abdruck einer dünnen kristallinen Schicht auf ein Empfänger- bzw. Aufnahmesubstrat, nach dem vorhergehenden Anspruch, **dadurch gekennzeichnet, dass** die Anhaftung der dünnen Schicht (7) auf einer Oberfläche eines Empfänger- bzw. Aufnahmesubstrats (9) durch Ausbilden einer Haftschicht (8) auf der dünnen Schicht und/oder auf dem Aufnahme- bzw. Empfängersubstrat (9) erfolgt.

11. Verfahren zum Abziehen bzw. Abdruck einer dünnen kristallinen Schicht auf ein Aufnahme- bzw. Empfängersubstrat, nach Anspruch 9, **dadurch gekennzeichnet, dass** die Anhaftung der dünnen Schicht (7) auf einer Oberfläche eines Aufnahme- bzw. Empfängersubstrats (9) durch Klebung mittels Molekularadhäsion erfolgt.

12. Verfahren zum Abziehen bzw. Abdruck einer dünnen kristallinen Schicht auf ein Aufnahme- bzw. Empfängersubstrat, nach einem beliebigen der Ansprüche 9 bis 11, **dadurch gekennzeichnet, dass** der Schritt der Ablösung bzw. Abtrennung der dünnen Schicht (7) unter Anwendung mechanischer und/oder chemischer Zwangsmassnahmen erfolgt.

13. Verfahren zum Abziehen bzw. Abdruck einer dünnen kristallinen Schicht auf ein Aufnahme- bzw. Empfängersubstrat, nach einem beliebigen der Ansprüche 9 bis 12, **dadurch gekennzeichnet, dass** das Verfahren nach der Stufe der Ausbildung der dünnen kristallinen Schicht (7) des Weiteren eine Stufe einer chemischen Einwirkung auf die Wachstumsmaske (20) aus dem zweiten Material umfasst.
